# EUROPEAN PATENT APPLICATION

(11) **EP 4 408 142 A1**
(43) Date of publication of application: **31.07.2024**
(21) Application number: 24153285.2
(22) Date of filing: 22.01.2024
(51) Int. Cl.: H10K 59/121

(54) **DISPLAY DEVICE**

(30) Priority: 27.01.2023 KR 20230010997
(71) Applicant: Samsung Display Co., Ltd., Yongin-si, Gyeonggi-do 17113 (KR)
(72) Inventor: LIM, Sang-Uk, 17113 Yongin-si (KR); KIM, Hyuk, 17113 Yongin-si (KR); BAEK, Seungsoo, 17113 Yongin-si (KR); LEE, Doo-Young, 17113 Yongin-si (KR); CHUNG, Boyong, 17113 Yongin-si (KR)
(74) Representative: Marks & Clerk LLP

(57) **Abstract**

A display device includes a first conductive layer disposed on a substrate and including a capacitor electrode, an active layer disposed on the first conductive layer and including a switching active pattern, the switching active pattern at least partially overlapping the capacitor electrode in a plan view and constituting a storage capacitor together with the capacitor electrode, a second conductive layer disposed on the active layer, a pixel electrode layer disposed on the second conductive layer and including a pixel electrode, the pixel electrode including a first part spaced apart from the switching active pattern in the plan view and a second part extending from the first part and overlapping the switching active pattern in the plan view, and a light emitting layer disposed on the pixel electrode layer.

## Description

### BACKGROUND

### 1. Technical Field

Embodiments provide generally to a display device. More particularly, embodiments relate to a display device that provides visual information.

### 2. Description of the Related Art

With the development of information technology, the importance of a display device, which is a connection medium between a user and information, has been highlighted. For example, the use of a display device such as a liquid crystal display device, an organic light emitting display device, a plasma display device, or the like is increasing. For example, the display device may include pixels each including at least one transistor, at least one capacitor, and at least one light emitting element.

### SUMMARY

Embodiments provide a display device with improved display quality.

The technical objectives to be achieved by the disclosure are not limited to those described herein, and other technical objectives that are not mentioned herein would be clearly understood by a person skilled in the art from the description of the disclosure.

A display device according to embodiments of the disclosure includes a first conductive layer disposed on a substrate and including a capacitor electrode, an active layer disposed on the first conductive layer and including a switching active pattern, the switching active pattern at least partially overlapping the capacitor electrode in a plan view and constituting a storage capacitor together with the capacitor electrode, a second conductive layer disposed on the active layer, a pixel electrode layer disposed on the second conductive layer and including a pixel electrode, the pixel electrode including a first part spaced apart from the switching active pattern in the plan view and a second part extending from the first part and overlapping the switching active pattern in the plan view, and a light emitting layer disposed on the pixel electrode layer.

The display device may further comprise the substrate.

The capacitor electrode of the storage capacitor may be electrically connected to the pixel electrode. The connection may be formed by a connection pattern in the second conductive layer.

In an embodiment, the second part of the pixel electrode may overlap an entirety of the storage capacitor in the plan view

In an embodiment, the active layer may further include a driving active pattern at least partially overlapping the capacitor electrode in the plan view and an initialization active pattern spaced apart from the driving active pattern and the switching active pattern in the plan view.

In an embodiment, the second conductive layer may include a gate electrode pattern at least partially overlapping the driving active pattern in the plan view and constituting a driving transistor together with the driving active pattern and a connection pattern at least partially overlapping the capacitor electrode in the plan view and electrically connected to the driving active pattern through contact holes.

In an embodiment, the pixel electrode may overlap an entirety of the gate electrode pattern in the plan view

In an embodiment, the gate electrode pattern may be electrically connected to the switching active pattern through a contact hole.

In an embodiment, the second part of the pixel electrode may be electrically connected to the connection pattern through a via hole. The via hole may be formed through one or more insulating layers separating the second conductive layer and the pixel electrode layer.

In an embodiment, the display device may further include a common electrode disposed on the light emitting layer. The pixel electrode, the light emitting layer, and the common electrode may constitute a light emitting element. The light emitting element may be electrically connected to the driving transistor. The storage capacitor may be electrically connected to the light emitting element. The capacitor electrode of the storage capacitor may be electrically connected to the pixel electrode of the light emitting element.

In an embodiment, the light emitting element may define a sub-pixel that emits red light.

In an embodiment, the second conductive layer may include a first scan line at least partially overlapping the switching active pattern in the plan view and may constituting a switching transistor together with a part of the switching active pattern, and a second scan line at least partially overlapping the initialization active pattern in the plan view and constituting an initialization transistor together with a part of the initialization active pattern.

In an embodiment, the first scan line may include a main part extending in a first direction and a branch part protruding and extending from the main part in a second direction intersecting the first direction. The branch part of the first scan line may at least partially overlap the switching active pattern in the plan view.

In an embodiment, the second scan line may include a main part extending in a first direction and a branch part protruding and extending from the main part in a second direction intersecting the first direction. The branch part of the second scan line may at least partially overlap the initialization active pattern in the plan view

In an embodiment, the first conductive layer may further include a driving voltage line extending in a second direction and electrically connected to the driving active pattern, a data line extending in the second direction, spaced apart from the driving voltage line in a first direction intersecting the second direction, and electrically connected to the switching active pattern, and an initialization voltage line extending in the second direction, spaced apart from the driving voltage line in a direction opposite to the first direction, and electrically connected to the initialization active pattern.

In an embodiment, the active layer may include a metal oxide semiconductor.

In some embodiments, the switching active pattern may be referred to as a further capacitor electrode. A display device according to such embodiments of the disclosure includes a first conductive layer disposed on a substrate and including a capacitor electrode, an active layer disposed on the first conductive layer and including a further capacitor electrode, the further capacitor electrode at least partially overlapping the capacitor electrode in a plan view and constituting a storage capacitor together with the capacitor electrode, a second conductive layer disposed on the active layer, a pixel electrode layer disposed on the second conductive layer and including a pixel electrode, the pixel electrode including a first part spaced apart from the further capacitor electrode in the plan view and a second part extending from the first part and overlapping the further capacitor electrode in the plan view, and a light emitting layer disposed on the pixel electrode layer.

A display device according to embodiments of the disclosure includes a first conductive layer disposed on a substrate and including a capacitor electrode, an active layer disposed on the first conductive layer and including a switching active pattern at least partially overlapping the capacitor electrode in a plan view and constituting a storage capacitor together with the capacitor electrode and a driving active pattern at least partially overlapping the capacitor electrode in the plan view, a second conductive layer disposed on the active layer and including a gate electrode pattern at least partially overlapping the driving active pattern in the plan view and constituting a driving transistor together with the driving active pattern, a pixel electrode layer disposed on the second conductive layer and including a pixel electrode including: a first pixel electrode electrically connected to the driving transistor, a part of the first pixel electrode overlapping the switching active pattern in the plan view, a second pixel electrode spaced apart from the first pixel electrode, and a third pixel electrode spaced apart from the first and second pixel electrodes, and a light emitting layer disposed on the pixel electrode layer.

In an embodiment, the part of the first pixel electrode may overlap an entirety of the storage capacitor in the plan view

In an embodiment, the second conductive layer may further include a connection pattern at least partially overlapping the capacitor electrode in the plan view and being electrically connected to the driving active pattern through contact holes.

In an embodiment, the part of the first pixel electrode may be electrically connected to the connection pattern through a via hole. The via hole may be formed through one or more insulating layers separating the second conductive layer and the first pixel electrode layer.

In an embodiment, the first pixel electrode may overlap an entirety of the gate electrode pattern in the plan view

In an embodiment, the gate electrode pattern may be electrically connected to the switching active pattern through a contact hole.

In an embodiment, the display device may further include a common electrode disposed on the light emitting layer. The first pixel electrode, the light emitting layer, and the common electrode may constitute a first light emitting element, the second pixel electrode, the light emitting layer, and the common electrode may constitute a second light emitting element, and the third pixel electrode, the light emitting layer, and the common electrode may constitute a third light emitting element.

In an embodiment, the first light emitting element may define a first sub-pixel that emits red light, the second light emitting element may define a second sub-pixel that emits green light, and the third light emitting element may define a third sub-pixel that emits blue light.

In an embodiment, the active layer may further include an initialization active pattern spaced apart from the driving active pattern and the switching active pattern in the plan view

In an embodiment, the second conductive layer may further include a first scan line at least partially overlapping the switching active pattern in the plan view and constituting a switching transistor together with a part of the switching active pattern and a second scan line at least partially overlapping the initialization active pattern in the plan view and constituting an initialization transistor together with a part of the initialization active pattern.

A display device according to embodiments of the disclosure includes a first conductive layer including a capacitor electrode, an active layer disposed on the first conductive layer and including a switching active pattern at least partially overlapping the capacitor electrode in a plan view and constituting a storage capacitor together with the capacitor electrode, a second conductive layer disposed on the active layer, and a pixel electrode layer disposed on the second conductive layer and including a pixel electrode, a part of the pixel electrode overlapping the switching active pattern in the plan view.

In this case, the switch active pattern may be electrically connected to a gate electrode of the driving transistor. A part of the pixel electrode may overlap the entirety of the storage capacitor in the plan view

Accordingly, formation of a parasitic capacitor between the switching active pattern and a common electrode disposed on the switching active pattern can be minimized or prevented, and the display quality of the display device can be improved.

At least some of the above and other features of the invention are set out in the claims.

### BRIEF DESCRIPTION OF THE DRAWINGS

Illustrative, non-limiting embodiments will be more clearly understood from the following detailed description in conjunction with the accompanying drawings.
FIG. 1 is a schematic plan view illustrating a display device according to embodiments.
FIG. 2 is a schematic diagram of an equivalent circuit for explaining a sub-pixel included in the display device of FIG. 1.
FIG. 3 is a schematic cross-sectional view of the display device of FIG. 1.
FIGS. 4, 5, 6, 7, 8, 9, and 10 are schematic layout views for explaining one pixel included in the display device of FIG. 1.
FIG. 11 is a schematic cross-sectional view taken along line I-I' of FIG. 10.

### DETAILED DESCRIPTION OF THE EMBODIMENTS

Hereinafter, a display device according to embodiments of the disclosure will be explained in detail with reference to the accompanying drawings. The same reference numerals are used for the same components in the drawings, and redundant descriptions of the same components will be omitted.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements.

The term "and/or" includes all combinations of one or more of which associated configurations may define. For example, "A and/or B" may be understood to mean "A, B, or A and B."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

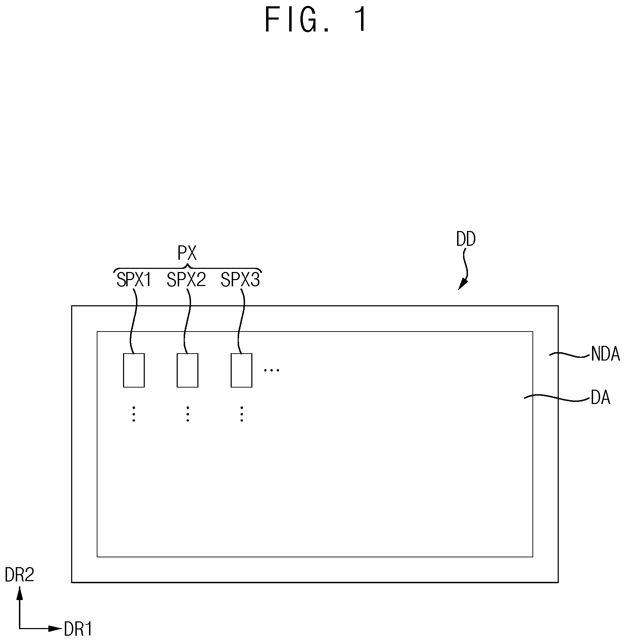

FIG. 1 is a schematic plan view illustrating a display device according to embodiments.

Referring to FIG. 1, a display device DD according to embodiments may be divided into a display area DA and a non-display area NDA. The display area DA may be an area capable of displaying an image by generating light or adjusting transmittance of light provided from an external light source. The non-display area NDA may be an area not displaying an image. The non-display area NDA may be positioned around the display area DA. For example, the non-display area NDA may surround the display area DA.

The display device DD may have a rectangular planar shape. However, embodiments of the disclosure are not limited thereto, and the display device DD may have various planar shapes (e.g., a rectangular planar shape with rounded corners).

Pixels PX may be arranged in the display area DA. By emitting light from the pixels PX, the display area DA may display an image.

Each of the pixels PX may include a first sub-pixel SPX1, a second sub-pixel SPX2, and a third sub-pixel SPX3. In an embodiment, the first sub-pixel SPX1 may be a green sub-pixel that emits green light, the second sub-pixel SPX2 may be a red sub-pixel that emits red light, and the third sub-pixel SPX3 may be a blue sub-pixel that emits blue light. However, the color of light emitted from each of the first, second, and third sub-pixels SPX1, SPX2, and SPX3 is not limited thereto. Although the number of the first, second, and third sub-pixels SPX1, SPX2, and SPX3 is shown as three, it is not limited thereto. For example, each of the pixels PX may further include a fourth sub-pixel that emits white light.

The pixels PX may be arranged in a matrix form in a first direction DR1 and a second direction DR2 intersecting the first direction DR1. Accordingly, each of the first sub-pixel SPX1, the second sub-pixel SPX2, and the third sub-pixel SPX3 may be arranged in a matrix form in the first and second directions DR1 and DR2.

Drivers may be disposed in the non-display area NDA. For example, the drivers may include a gate driver and a data driver. The drivers may be electrically connected to the pixels PX. The drivers may provide signals and voltages for emitting the light to the pixels PX.

In this specification, a plane may be defined as the first direction DR1 and the second direction DR2 intersecting the first direction DR1. For example, the first direction DR1 may be perpendicular to the second direction DR2.

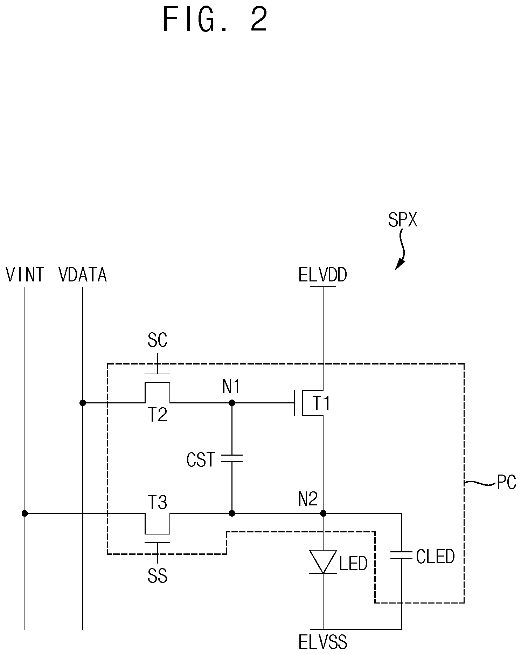

FIG. 2 is a schematic diagram of an equivalent circuit for explaining a sub-pixel included in the display device of FIG. 1. For example, the sub-pixel SPX of FIG. 2 may correspond to any one of the first, second, and third sub-pixels SPX1, SPX2, and SPX3 of FIG. 1.

Referring to FIG. 2, the sub-pixel SPX may include a pixel circuit PC and a light emitting element LED electrically connected to the pixel circuit PC. The pixel circuit PC may include first, second, and third transistors T1, T2, and T3, a storage capacitor CST, and/or a light emitting portion capacitor CLED.

The first transistor T1 may include a first electrode, a gate electrode, and a second electrode. The gate electrode of the first transistor T1 may be connected to a first node N1. A driving voltage ELVDD may be applied to the first electrode of the first transistor T1. The second electrode of the first transistor T1 may be connected to a second node N2. The first transistor T1 may receive the driving voltage ELVDD from a driving voltage line corresponding to the voltage of the first node N1 and may supply a driving current to the light emitting element LED. For example, the first transistor T1 may be a driving transistor for driving the light emitting element LED.

The second transistor T2 may include a first electrode, a gate electrode, and a second electrode. A first scan signal SC may be applied to the gate electrode of the second transistor T2. A data voltage VDATA may be applied to the first electrode of the second transistor T2. The second electrode of the second transistor T2 may be connected to the first node N1. The second transistor T2 may be turned on by the first scan signal SC to electrically connect a data line providing the data voltage VDATA to the first node N1. For example, the second transistor T2 may be a switching transistor.

The third transistor T3 may include a first electrode, a gate electrode, and a second electrode. A second scan signal SS may be applied to the gate electrode of the third transistor T3. An initialization voltage VINT may be applied to the first electrode of the third transistor T3. The second electrode of the third transistor T3 may be connected to the second node N2. The third transistor T3 may be turned on by the second scan signal SS to electrically connect an initialization voltage line providing the initialization voltage VINT to the second node N2. For example, the third transistor T3 may be an initialization transistor.

The storage capacitor CST may include a first electrode and a second electrode. The first electrode of the storage capacitor CST may be connected to the first node N1. The second electrode of the storage capacitor CST may be connected to the second node N2. The storage capacitor CST may store a difference voltage between a gate voltage and a source voltage of the first transistor T1.

The light emitting portion capacitor CLED may include a first electrode and a second electrode. The first electrode of the light emitting portion capacitor CLED may be connected to the second node N2. The second electrode of the light emitting portion capacitor CLED may be connected to the second electrode of the light emitting element LED. As the light emitting portion capacitor CLED maintains a constant voltage across the light emitting element LED, the light emitting element LED may display constant luminance.

The light emitting element LED may include a first electrode (e.g., an anode electrode) and a second electrode (e.g., a cathode electrode). The first electrode of the light emitting element LED may be connected to the second node N2. A common voltage ELVSS may be applied to the second electrode of the light emitting element LED. The light emitting element LED may emit light with a luminance corresponding to the driving current provided from the pixel circuit PC.

However, in FIG. 2, one sub-pixel SPX is illustrated as including three transistors T1, T2, and T3, one storage capacitor CST, and one light emitting portion capacitor CLED, embodiments of the disclosure are not limited thereto.

Although one sub-pixel SPX is illustrated as including one light emitting element LED in FIG. 2, embodiments of the disclosure are not limited thereto. For example, a sub-pixel SPX may include two or more light emitting elements.

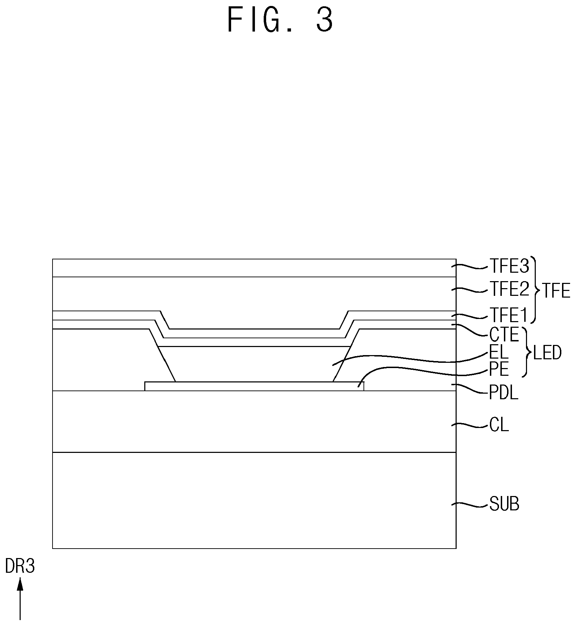

FIG. 3 is a schematic cross-sectional view of the display device of FIG. 1.

Referring to FIG. 3, the display device DD according to embodiments may include a substrate SUB, a circuit layer CL, the light emitting element LED, a pixel defining layer PDL, and/or an encapsulation layer TFE.

The substrate SUB may include a transparent material, semi-transparent material, and/or an opaque material. In an embodiment, the substrate SUB may be made of a transparent resin substrate. Examples of the transparent resin substrate may include polyimide substrates or the like. The polyimide substrate may include, e.g., a first organic layer, a first barrier layer, a second organic layer, or the like. As another example, examples of the substrate SUB may include a quartz substrate, a synthetic quartz substrate, a calcium fluoride substrate, an F-doped quartz substrate, a sodalime glass substrate, a non-alkali glass substrate, or the like. These may be used alone or in combination with each other.

The circuit layer CL may be disposed on the substrate SUB. The circuit layer CL may provide signals and voltages for the light emitting element LED to emit light to the light emitting element LED. For example, the circuit layer CL may include a transistor, a conductive layer, an insulating layer, or the like.

A pixel electrode PE may be disposed on the circuit layer CL. The pixel electrode PE may receive the signals and the voltages from the circuit layer CL. For example, the pixel electrode PE may include a metal, an alloy, a metal nitride, a conductive metal oxide, a transparent conductive material, or the like. These may be used alone or in combination with each other. For example, the pixel electrode PE may be an anode electrode. As another example, the pixel electrode PE may be a cathode electrode.

The pixel defining layer PDL may be disposed on the circuit layer CL and the pixel electrode PE. The pixel defining layer PDL may have an opening exposing a part of the pixel electrode PE. As the pixel defining layer PDL has the opening, the pixel defining layer PDL may define each sub-pixel (e.g., the sub-pixel SPX of FIG. 2) that emits light. The pixel defining layer PDL may include an organic material or an inorganic material. Examples of the organic material that can be used for the pixel defining layer PDL may include photoresist, polyacrylic-based resin, polyimide-based resin, polyamide-based resin, siloxane-based resin, acrylic-based resin, epoxy-based resin, or the like. These may be used alone or in combination with each other.

A light emitting layer EL may be disposed on the pixel electrode PE. The light emitting layer EL may be disposed in the opening of the pixel defining layer PDL. The light emitting layer EL may include light emitting materials for emitting light. FIG. 3 only illustrates an organic light emitting layer among the layers included in the light emitting layer EL.

A common electrode CTE may be disposed on the pixel defining layer PDL and the light emitting layer EL. For example, the common electrode CTE may include a metal, an alloy, a metal nitride, a conductive metal oxide, a transparent conductive material, or the like. These may be used alone or in combination with each other. For example, the common electrode CTE may be a cathode electrode. As another example, the common electrode CTE may be an anode electrode.

Accordingly, the light emitting element LED including the pixel electrode PE, the light emitting layer EL, and the common electrode CTE may be disposed on the substrate SUB.

The encapsulation layer TFE may be disposed on the common electrode CTE. The encapsulation layer TFE may protect the light emitting element LED from external oxygen and moisture. The encapsulation layer TFE may include at least one inorganic layer and at least one organic layer. For example, the encapsulation layer TFE may include a first inorganic layer TFE1 disposed on the common electrode CTE, an organic layer TFE2 disposed on the first inorganic layer TFE1, and a second inorganic layer TFE3 disposed on the organic layer TFE2.

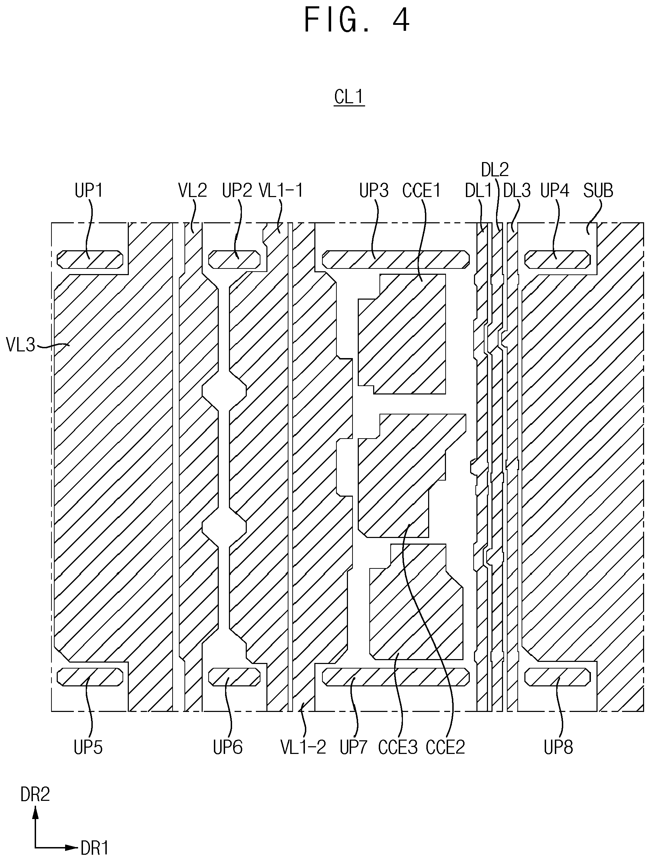

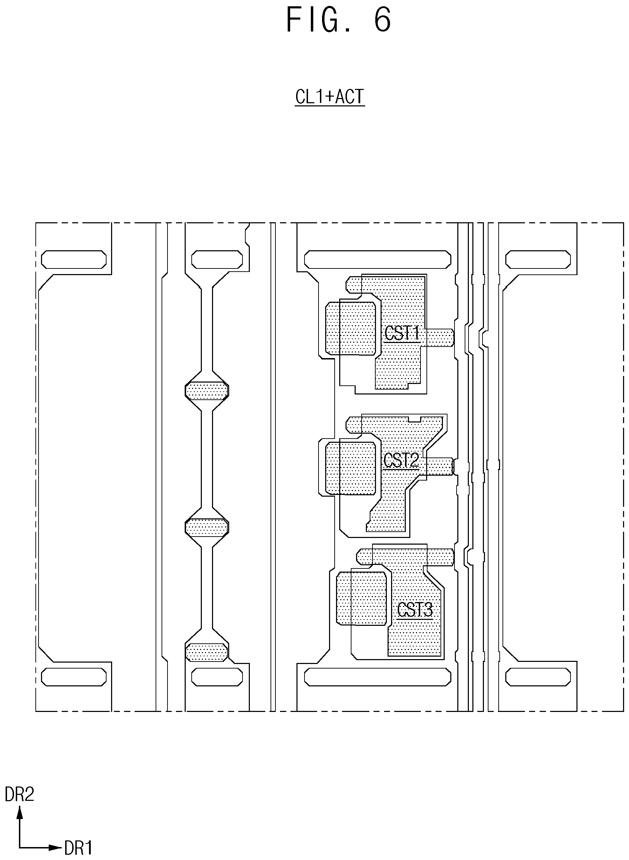

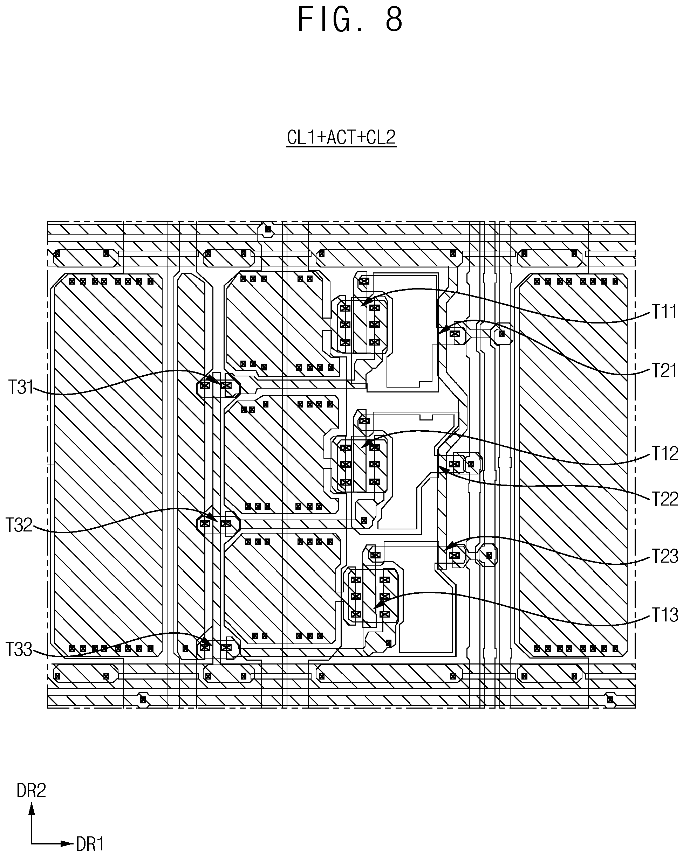

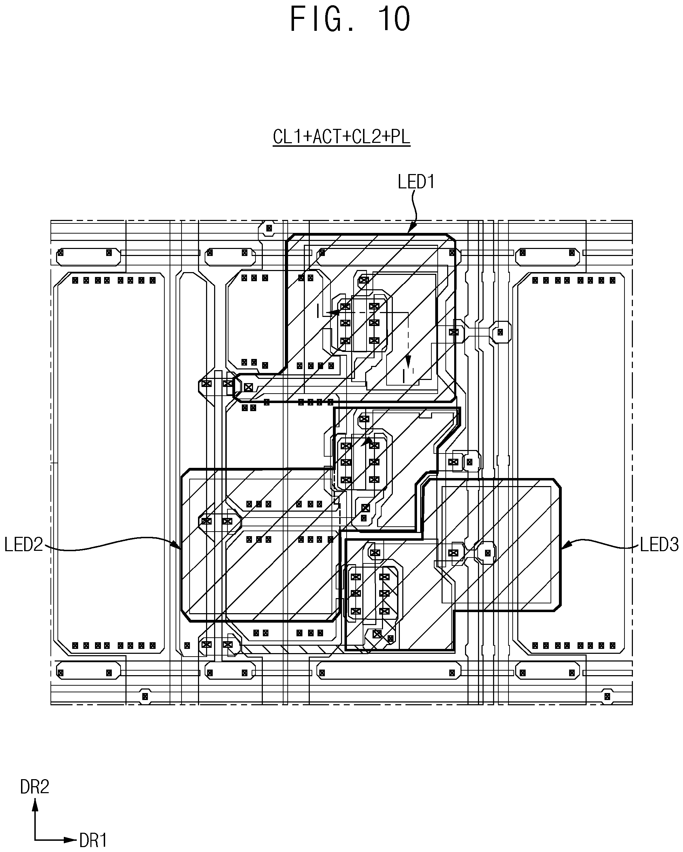

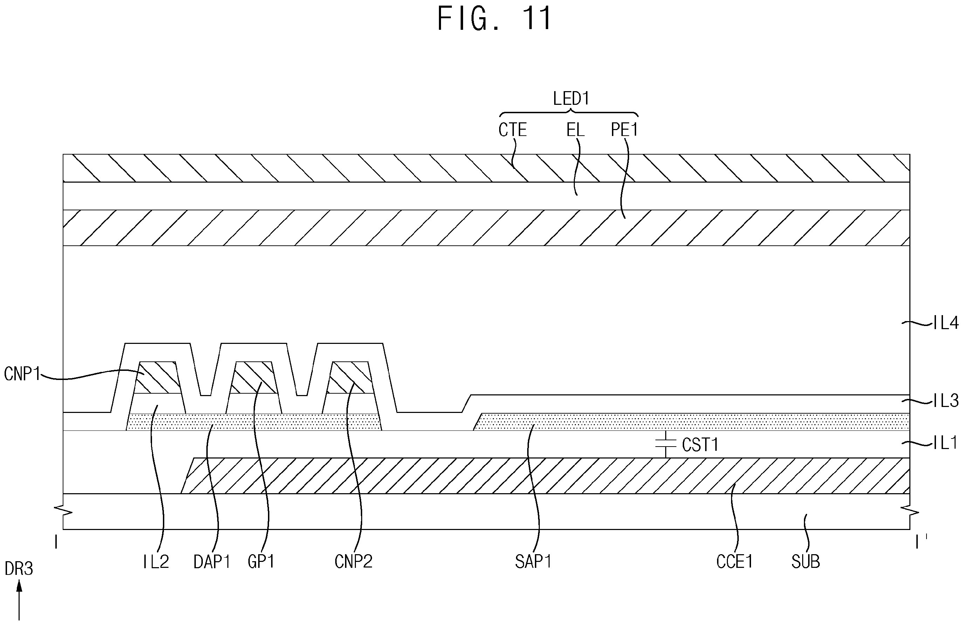

FIGS. 4, 5, 6, 7, 8, 9, and 10 are schematic layout views for explaining a pixel included in the display device of FIG. 1. FIG. 11 is a schematic cross-sectional view taken along line I-I' of FIG. 10.

The layer-by-layer structure of a pixel PX included in the display device DD will be described in detail with reference to FIGS. 4, 5, 6, 7, 8, 9, 10, and 11.

Referring to FIGS. 4 and 11, the display device DD according to embodiments includes a first conductive layer CL1. The first conductive layer CL1 is disposed on the substrate SUB.

The first conductive layer CL1 may include first, second, and third capacitor electrodes CCE1, CCE2, and CCE3, first and second driving voltage lines VL1-1 and VL1-2, an initialization voltage line VL2, a common voltage line VL3, first, second, and third data lines DL1, DL2, and DL3, and first, second, third, fourth, fifth, sixth, seventh, and eighth lower metal patterns UP1, UP2, UP3, UP4, UPS, UP6, UP7, and UP8.

The first, second, and third capacitor electrodes CCE1, CCE2, and CCE3, the first and second driving voltage lines VL1-1 and VL1-2, the initialization voltage line VL2, the common voltage line VL3, the first, second, and third data lines DL1, DL2, and DL3, and the first, second, third, fourth, fifth, sixth, seventh, and eighth lower metal patterns UP1, UP2, UP3, UP4, UP5, UP6, UP7, and UP8 may include a same material and may be disposed in a same layer. The first, second, and third capacitor electrodes CCE1, CCE2, and CCE3, the first and second driving voltage lines VL1-1 and VL1-2, the initialization voltage line VL2, the common voltage line VL3, the first, second, and third data lines DL1, DL2, and DL3, and the first, second, third, fourth, fifth, sixth, seventh, and eighth lower metal patterns UP1, UP2, UP3, UP4, UP5, UP6, UP7, and UP8 may be spaced apart from each other.

The first and second driving voltage lines VL1-1 and VL1-2 may be adjacent to each other. Each of the first and second driving voltage lines VL1-1 and VL1-2 may extend in the second direction DR2. A driving voltage (e.g., the driving voltage ELVDD of FIG. 2) may be applied to the first and second driving voltage lines VL1-1 and VL1-2.

The initialization voltage line VL2 may be spaced apart from the first and second driving voltage lines VL1-1 and VL1-2 in a direction opposite to the first direction DR1. The initialization voltage line VL2 may extend in the second direction DR2. An initialization voltage (e.g., the initialization voltage VINT of FIG. 2) may be applied to the initialization voltage line VL2.

The common voltage line VL3 may be spaced apart from the initialization voltage line VL2 in a direction opposite to the first direction DR1. The common voltage line VL3 may extend in the second direction DR2. A common voltage (e.g., the common voltage ELVSS of FIG. 2) may be applied to the common voltage line VL3.

The first data line DL1 may be spaced apart from the first and second driving voltage lines VL1-1 and VL1-2 in the first direction DR1. The first data line DL1 may extend in the second direction DR2. A data voltage (e.g., the data voltage VDATA of FIG. 2) may be applied to the first data line DL1.

The second data line DL2 may be spaced apart from the first and second driving voltage lines VL1-1 and VL1-2 in the first direction DR1. The second data line DL2 may extend in the second direction DR2. A data voltage (e.g., the data voltage VDATA of FIG. 2) may be applied to the second data line DL2.

The third data line DL3 may be spaced apart from the first and second driving voltage lines VL1-1 and VL1-2 in the first direction DR1. The third data line DL3 may extend in the second direction DR2. A data voltage (e.g., the data voltage VDATA of FIG. 2) may be applied to the third data line DL3.

For example, the first, second, and third data lines DL1, DL2, and DL3 may be adjacent to each other. The first data line DL1 may be electrically connected to a second sub-pixel (e.g., the second sub-pixel SPX2 of FIG. 1), the second data line DL2 may be electrically connected to a third sub-pixel (e.g., the third sub-pixel SPX3 of FIG. 1), and third data line DL3 may be electrically connected to a first sub-pixel (e.g., the first sub-pixel SPX1 of FIG. 1). In other words, the first, second, and third data lines DL1, DL2, and DL3 may be electrically connected to different sub-pixels, respectively.

The first, second, and third capacitor electrodes CCE1, CCE2, and CCE3 may be positioned between the second driving voltage line VL1-2 and the first data line DL1 in the plan view. The first, second, and third capacitor electrodes CCE1, CCE2, and CCE3 may be spaced apart from each other in the second direction DR2.

The first, second, third, and fourth lower metal patterns UP1, UP2, UP3, and UP4 may be spaced apart from each other in the first direction DR1. In detail, the first lower metal pattern UP1 may be adjacent to the common voltage line VL3, and the fourth lower metal pattern UP4 may be adjacent to the third data line DL3. In the plan view, the second lower metal pattern UP2 may be positioned between the initialization voltage line VL2 and the first driving voltage line VL1-1, and the third lower metal pattern UP3 may be positioned between the second driving voltage line VL1-2 and the first data line DL1.

The fifth, sixth, seventh, and eighth lower metal patterns UP5, UP6, UP7, and UP8 may be spaced apart from each other in the first direction DR1. The fifth lower metal pattern UPS may face the first lower metal pattern UP1 in the second direction DR2, the sixth lower metal pattern UP6 may face the second lower metal pattern UP2 in the second direction DR2, the seventh lower metal pattern UP7 may face the third lower metal pattern UP3 in the second direction DR2, and the eighth lower metal pattern UP8 may face the fourth lower metal pattern UP4 in the second direction DR2.

The first conductive layer CL1 may include a metal, an alloy, a conductive metal oxide, a transparent conductive material, or the like. Examples of the metal that can be used for the first conductive layer CL1 may include silver (Ag), molybdenum (Mo), aluminum (Al), tungsten (W), copper (Cu), nickel (Ni), chromium. (Cr), titanium (Ti), tantalum (Ta), platinum (Pt), scandium (Sc), indium (In), or the like. Examples of the conductive metal oxide that can be used for the first conductive layer CL1 may include indium tin oxide (ITO), indium zinc oxide (IZO), indium tin zinc oxide (ITZO), or the like. Each of these may be used alone or in combination with each other. However, embodiments of the disclosure are not limited thereto.

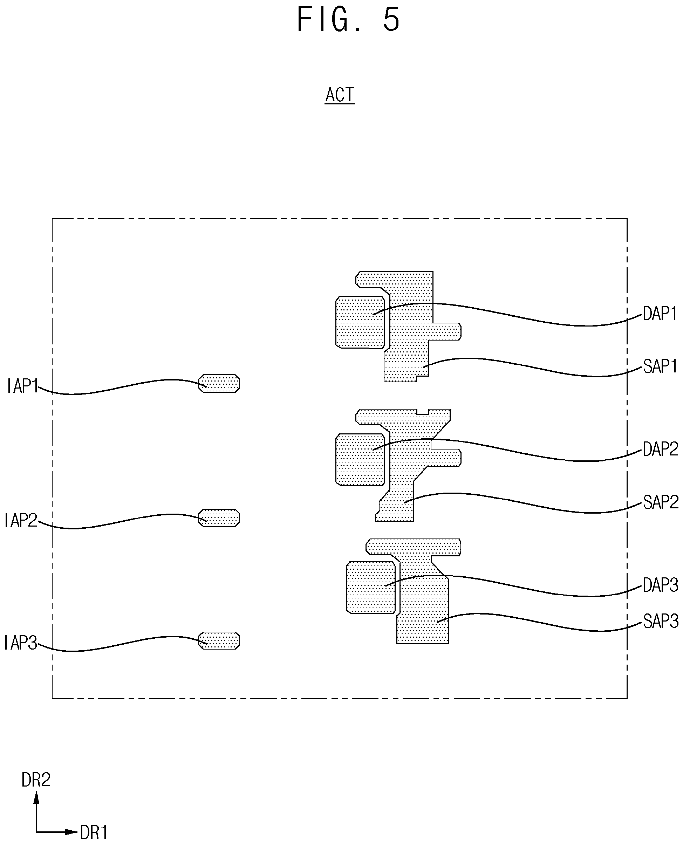

Further referring to FIGS. 5, 6, and 11, the display device DD according to embodiments further includes an active layer ACT. The active layer ACT is disposed on the first conductive layer CL1. A first insulating layer IL1 may be disposed on the first conductive layer CL1, and the active layer ACT may be disposed on the first insulating layer IL1. For example, the first insulating layer IL1 may include an inorganic material such as silicon oxide, silicon nitride, silicon oxynitride, or the like. These may be used alone or in combination with each other.

The active layer ACT may include first, second, and third driving active patterns DAP1, DAP2, and DAP3, first, second, and third switching active patterns SAP1, SAP2, and SAP3, and first, second, and third initialization active patterns IAP1, IAP2, and IAP3.

The first, second, and third driving active patterns DAP1, DAP2, DAP3, the first, second, and third switching active patterns SAP1, SAP2, and SAP3, and the first, second, and third initialization active patterns IAP1, IAP2, IAP3 may include a same material and may be disposed in a same layer.

The first, second, and third driving active patterns DAP1, DAP2, and DAP3 may be spaced apart from each other in the second direction DR2. The first, second, and third switching active patterns SAP1, SAP2, and SAP3 may be spaced apart from each other in the second direction DR2. The first, second, and third initialization active patterns IAP1, IAP2, and IAP3 may be spaced apart from each other in the second direction DR2.

The first driving active pattern DAP1 may at least partially overlap the first capacitor electrode CCE1 in the plan view. For example, the first driving active pattern DAP1 may overlap at least a part of the first capacitor electrode CCE1 in the plan view.

The second driving active pattern DAP2 may at least partially overlap the second capacitor electrode CCE2 in the plan view. For example, the second driving active pattern DAP2 may overlap at least a part of the second capacitor electrode CCE2 in the plan view.

The third driving active pattern DAP3 may at least partially overlap the third capacitor electrode CCE3 in the plan view. For example, the third driving active pattern DAP3 may overlap at least a part of the third capacitor electrode CCE3 in the plan view

The first switching active pattern SAP1 may at least partially overlap the first capacitor electrode CCE1 in the plan view. For example, the first switching active pattern SAP1 may overlap at least a part of the first capacitor electrode CCE1 in the plan view. Accordingly, the first switching active pattern SAP1 may constitute a first storage capacitor CST1 together with the first capacitor electrode CCE1. For example, the first storage capacitor CST1 may be constituted by the first switching active pattern SAP1 and a part of the first capacitor electrode CCE1 overlapping the first switching active pattern SAP1.

The second switching active pattern SAP2 at least partially overlaps the second capacitor electrode CCE2 in the plan view. For example, the second switching active pattern SAP2 may overlap at least a part of the second capacitor electrode CCE2 in the plan view. Accordingly, the second switching active pattern SAP2 constitutes a second storage capacitor CST2 together with the second capacitor electrode CCE2. For example, the second storage capacitor CST2 may be constituted by the second switching active pattern SAP2 and a part of the second capacitor electrode CCE2 overlapping the second switching active pattern SAP2.

The third switching active pattern SAP3 may at least partially overlap the third capacitor electrode CCE3 in the plan view. For example, the third switching active pattern SAP3 may overlap at least a part of the third capacitor electrode CCE3 in the plan view. Accordingly, the third switching active pattern SAP3 may constitute a third storage capacitor CST3 together with the third capacitor electrode CCE3. For example, the third storage capacitor CST3 may be constituted by the third switching active pattern SAP3 and a part of the third capacitor electrode CCE3 overlapping the third switching active pattern SAP3.

Each of the first, second, and third storage capacitors CST1, CST2, and CST3 may correspond to the storage capacitor CST shown in FIG. 2.

Each of the first, second, and third initialization active patterns IAP1, IAP2, and IAP3 may be positioned between the initialization voltage line VL2 and the first driving voltage line VL1-1 in the plan view.

In an embodiment, the active layer ACT may include a metal oxide semiconductor. Examples of materials that may be used for the metal oxide semiconductor may include a binary compound (ABₓ), a ternary compound (ABₓC_{y}), a quaternary compound (ABₓC_{y}D_{z}), or the like containing indium (In), zinc (Zn), gallium (Ga), tin (Sn), titanium (Ti), aluminum (Al), hafnium (Hf), zirconium (Zr), magnesium (Mg), or the like. For example, the metal oxide semiconductor may include zinc oxide (ZnOₓ), gallium oxide (GaOₓ), tin oxide (SnOₓ), indium oxide (InOₓ), indium gallium oxide (IGO), indium zinc oxide (IZO), indium tin oxide. (ITO), indium zinc tin oxide (IZTO), indium gallium zinc oxide (IGZO), or the like. These may be used alone or in combination with each other.

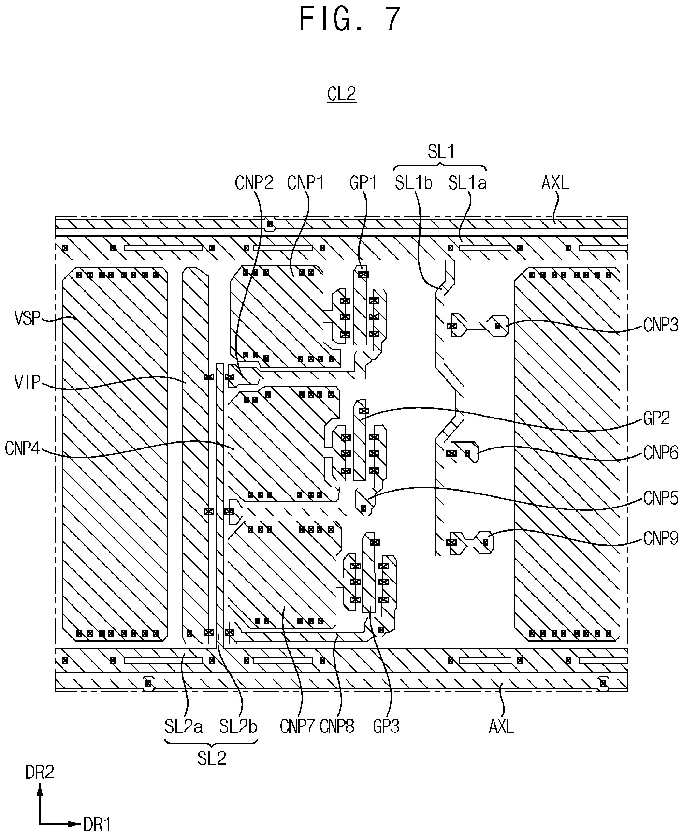

Further referring to FIGS. 7, 8, and 11, the display device DD according to embodiments further includes a second conductive layer CL2. The second conductive layer CL2 is disposed on the active layer ACT. The second insulating layer IL2 may be disposed on the active layer ACT, and the second conductive layer CL2 may be disposed on the second insulating layer IL2. The second insulating layer IL2 may be positioned only between the active layer ACT and the second conductive layer CL2. For example, the second insulating layer IL2 may include an inorganic material such as silicon oxide, silicon nitride, silicon oxynitride, or the like. These may be used alone or in combination with each other.

The second conductive layer CL2 may include a common voltage auxiliary pattern VSP, an initialization voltage auxiliary pattern VIP, first and second scan lines SL1 and SL2, auxiliary lines AXL, first, second, and third gate electrode patterns GP1, GP2, and GP3, and first, second, third, fourth, fifth, sixth, seventh, eighth, and ninth connection patterns CNP1, CNP2, CNP3, CNP4, CNP5, CNP6, CNP7, CNP8, and CNP9.

The common voltage auxiliary pattern VSP, the initialization voltage auxiliary pattern VIP, the first and second scan lines SL1 and SL2, the auxiliary lines AXL, the first, second, and third gate electrode patterns GP1, GP2, and GP3, and the first, second, third, fourth, fifth, sixth, seventh, eighth, and ninth connection patterns CNP1, CNP2, CNP3, CNP4, CNP5, CNP6, CNP7, CNP8, and CNP9 may include a same material and may be disposed in a same layer. The common voltage auxiliary pattern VSP, the initialization voltage auxiliary pattern VIP, the first and second scan lines SL1 and SL2, the auxiliary lines AXL, the first, second, and third gate electrode patterns GP1, GP2, and GP3, and the first, second, third, fourth, fifth, sixth, seventh, eighth, and ninth connection patterns CNP1, CNP2, CNP3, CNP4, CNP5, CNP6, CNP7, CNP8, and CNP9 may be spaced apart from each other in the plan view

The first gate electrode pattern GP1 may at least partially overlap each of the first capacitor electrode CCE1 and the first driving active pattern DAP1 in the plan view. Accordingly, the first driving active pattern DAP1 and a part (e.g., a gate electrode) of the first gate electrode pattern GP1 overlapping the first driving active pattern DAP1 may constitute a first driving transistor T11.

The first gate electrode pattern GP1 may be connected to the first switching active pattern SAP1 through a contact hole. Accordingly, the first switching active pattern SAP1 may be electrically connected to the first driving transistor T11.

The second gate electrode pattern GP2 may at least partially overlap each of the second capacitor electrode CCE2 and the second driving active pattern DAP2 in the plan view. Accordingly, the second driving active pattern DAP2 and a part (e.g., a gate electrode) of the second gate electrode pattern GP2 overlapping the second driving active pattern DAP2 may constitute a second driving transistor T12.

The second gate electrode pattern GP2 may be connected to the second switching active pattern SAP2 through a contact hole. Accordingly, the second switching active pattern SAP2 may be electrically connected to the second driving transistor T12.

The third gate electrode pattern GP3 may at least partially overlap each of the third capacitor electrode CCE3 and the third driving active pattern DAP3 in the plan view. Accordingly, the third driving active pattern DAP3 and a part (e.g., a gate electrode) of the third gate electrode pattern GP3 overlapping the third driving active pattern DAP3 may constitute a third driving transistor T13.

The third gate electrode pattern GP3 may be connected to the third switching active pattern SAP3 through a contact hole. Accordingly, the third switching active pattern SAP3 may be electrically connected to a third driving transistor T13.

The first scan line SL1 may include a main part SL1a extending in the first direction DR1 and a branch part SL1b protruding and extending from the main part SL1a in a direction opposite to the second direction DR2. The branch part SL1b of the first scan line SL1 may at least partially overlap each of the first, second, and third switching active patterns SAP1, SAP2, and SAP3 in the plan view A first scan signal (e.g., the first scan signal SC of FIG. 2) may be applied to the first scan line SL1.

Accordingly, a part of the first switching active pattern SAP1 and a part (e.g., a gate electrode) of the first scan line SL1 overlapping the first switching active pattern SAP1 may constitute a first switching transistor T21. A part of the second switching active pattern SAP2 and a part (e.g., a gate electrode) of the first scan line SL1 overlapping the second switching active pattern SAP2 may constitute a second switching transistor T22. A part of the third switching active pattern SAP3 and a part (e.g., a gate electrode) of the first scan line SL1 overlapping the third switching active pattern SAP3 may constitute a third switching transistor T23.

Each of the first, second, and third switching transistors T21, T22, and T23 may correspond to the second transistor T2 shown in FIG. 2.

The second scan line SL2 may include a main part SL2a extending in the first direction DR1 and a branch part SL2b protruding and extending from the main part SL2a in the second direction DR2. The branch part SL2b of the second scan line SL2 may at least partially overlap each of the first, second, and third initialization active patterns IAP1, IAP2, and IAP3 in the plan view. A second scan signal (e.g., the second scan signal SS of FIG. 2) may be applied to the second scan line SL2.

Accordingly, the first initialization active pattern IAP1 and a part (e.g., a gate electrode) of the second scan line SL2 overlapping the first initialization active pattern IAP1 may constitute a first initialization transistor T31. The second initialization active pattern IAP2 and a part (e.g., a gate electrode) of the second scan line SL2 overlapping the second initialization active pattern IAP2 may constitute a second initialization transistor T32. The third initialization active pattern IAP3 and a part (e.g., a gate electrode) of the second scan line SL2 overlapping the third initialization active pattern IAP3 may constitute a third initialization transistor T33.

Each of the first, second, and third initialization transistors T31, T32, and T33 may correspond to the third transistor T3 shown in FIG. 2.

The first connection pattern CNP1 may be connected to the first and second driving voltage lines VL1-1 and VL1-2 through contact holes. The first connection pattern CNP1 may be connected to the first driving active pattern DAP1 through contact holes. Accordingly, the first connection pattern CNP1 may electrically connect the first and second driving voltage lines VL1-1 and VL1-2 and the first driving active pattern DAP1. For example, the first driving transistor T11 may be electrically connected to the first and second driving voltage lines VL1-1 and VL1-2 through the first connection pattern CNP1.

The second connection pattern CNP2 may be connected to the first initialization active pattern IAP1 through a contact hole. The second connection pattern CNP2 may be connected to the first capacitor electrode CCE1 through a contact hole. The second connection pattern CNP2 may be connected to the first driving active pattern DAP1 through contact holes. Accordingly, the second connection pattern CNP2 may electrically connect the first initialization active pattern IAP1, the first capacitor electrode CCE1, and the first driving active pattern DAP1. For example, the first driving transistor T11 may be electrically connected to the first capacitor electrode CCE1 and the first initialization active pattern IAP1 through the second connection pattern CNP2.

The third connection pattern CNP3 may be connected to the first switching active pattern SAP1 through a contact hole. The third connection pattern CNP3 may be connected to the third data line DL3 through a contact hole. Accordingly, the third connection pattern CNP3 may electrically connect the first switching active pattern SAP1 and the third data line DL3. For example, the first switching transistor T21 may be electrically connected to the third data line DL3 through the third connection pattern CNP3.

The fourth connection pattern CNP4 may be connected to the first and second driving voltage lines VL1-1 and VL1-2 through contact holes. The fourth connection pattern CNP4 may be connected to the second driving active pattern DAP2 through contact holes. Accordingly, the fourth connection pattern CNP4 may electrically connect the first and second driving voltage lines VL1-1 and VL1-2 and the second driving active pattern DAP2. For example, the second driving transistor T12 may be electrically connected to the first and second driving voltage lines VL1-1 and VL1-2 through the fourth connection pattern CNP4.

The fifth connection pattern CNP5 may be connected to the second initialization active pattern IAP2 through a contact hole. The fifth connection pattern CNP5 may be connected to the second capacitor electrode CCE2 through a contact hole. The fifth connection pattern CNP5 may be connected to the second driving active pattern DAP2 through contact holes. Accordingly, the fifth connection pattern CNP5 may electrically connect the second initialization active pattern IAP2, the second capacitor electrode CCE2, and the second driving active pattern DAP2. For example, the second driving transistor T12 may be electrically connected to the second capacitor electrode CCE2 and the second initialization active pattern IAP2 through the fifth connection pattern CNP5.

The sixth connection pattern CNP6 may be connected to the second switching active pattern SAP2 through a contact hole. The sixth connection pattern CNP6 may be connected to the first data line DL1 through a contact hole. Accordingly, the sixth connection pattern CNP6 may electrically connect the second switching active pattern SAP2 and the first data line DL1. For example, the second switching transistor T22 may be electrically connected to the first data line DL1 through the sixth connection pattern CNP6.

The seventh connection pattern CNP7 may be connected to the first and second driving voltage lines VL1-1 and VL1-2 through contact holes. The seventh connection pattern CNP7 may be connected to the third driving active pattern DAP3 through contact holes. Accordingly, the seventh connection pattern CNP7 may electrically connect the first and second driving voltage lines VL1-1 and VL1-2 and the third driving active pattern DAP3. For example, the third driving transistor T13 may be electrically connected to the first and second driving voltage lines VL1-1 and VL1-2 through the seventh connection pattern CNP7.

The eighth connection pattern CNP8 may be connected to the third initialization active pattern IAP3 through a contact hole. The eighth connection pattern CNP8 may be connected to the third capacitor electrode CCE3 through a contact hole. The eighth connection pattern CNP8 may be connected to the third driving active pattern DAP3 through contact holes. Accordingly, the eighth connection pattern CNP8 may electrically connect the third initialization active pattern IAP3, the third capacitor electrode CCE3, and the third driving active pattern DAP3. For example, the third driving transistor T13 may be electrically connected to the third capacitor electrode CCE3 and the third initialization active pattern IAP3 through the eighth connection pattern CNP8.

The ninth connection pattern CNP9 may be connected to the third switching active pattern SAP3 through a contact hole. The ninth connection pattern CNP9 may be connected to the second data line DL2 through a contact hole. Accordingly, the ninth connection pattern CNP9 may electrically connect the third switching active pattern SAP3 and the second data line DL2. For example, the third switching transistor T23 may be electrically connected to the second data line DL2 through the ninth connection pattern CNP9.

The common voltage auxiliary pattern VSP may extend in the second direction DR2. The common voltage auxiliary pattern VSP may at least partially overlap the common voltage line VL3. For example, the common voltage auxiliary pattern VSP may be connected to the common voltage line VL3 through contact holes. The common voltage auxiliary pattern VSP may reduce the resistance of the common voltage line VL3.

The initialization voltage auxiliary pattern VIP may extend in the second direction DR2. The initialization voltage auxiliary pattern VIP may at least partially overlap the initialization voltage line VL2. For example, the initialization voltage auxiliary pattern VIP may be connected to the initialization voltage line VL2 through contact holes. The initialization voltage auxiliary pattern VIP may reduce the resistance of the initialization voltage line VL2.

The initialization voltage auxiliary pattern VIP may be connected to each of the first, second, and third initialization active patterns IAP1, IAP2, and IAP3 through a contact hole.

Each of the auxiliary lines AXL may extend in the first direction DR1. One of the auxiliary lines AXL may be adjacent to the first scan line SL1 and another of the auxiliary lines AXL may be adjacent to the second scan line SL2. One of the auxiliary lines AXL may be connected to the first driving voltage line VL1-1 through a contact hole. Another one of the auxiliary lines AXL may be connected to the common voltage line VL3 through a contact hole.

The second conductive layer CL2 may include, e.g., a metal, an alloy, a conductive metal oxide, a transparent conductive material, or the like. Examples of the metal that can be used for the second conductive layer CL2 may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), indium (In), or the like. Examples of the conductive metal oxide that can be used for the second conductive layer CL2 may include indium tin oxide (ITO), indium zinc oxide (IZO), indium tin zinc oxide (ITZO), or the like. Each of these may be used alone or in combination with each other. However, embodiments of the disclosure are not limited thereto.

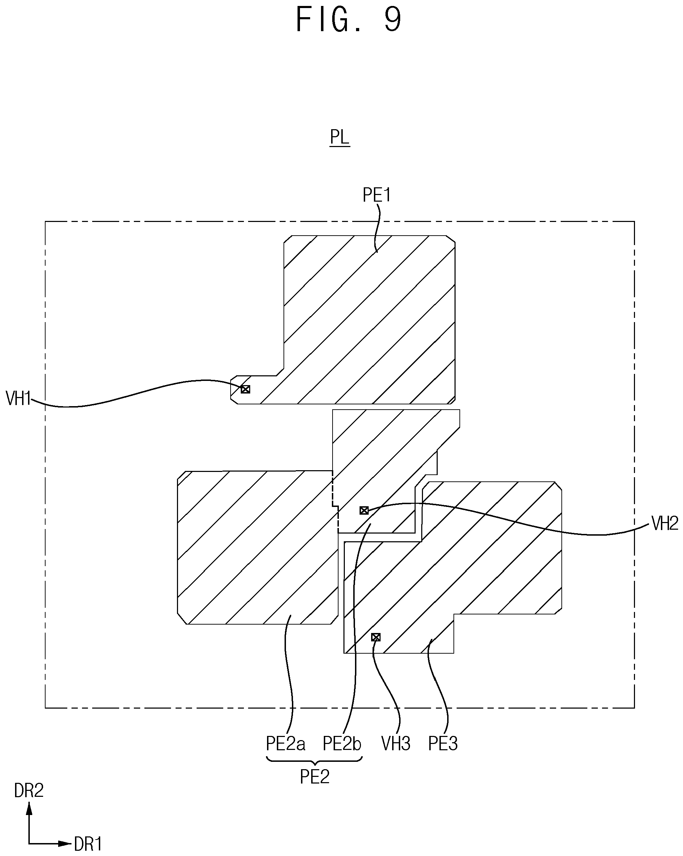

Further referring to FIGS. 9, 10, and 11, the display device DD according to embodiments further includes a pixel electrode layer PL. The pixel electrode layer PL is disposed on the second conductive layer CL2. A third insulating layer IL3 and a fourth insulating layer IL4 may be sequentially disposed on the second conductive layer CL2, and the pixel electrode layer PL may be disposed on the fourth insulating layer IL4.

For example, the third insulating layer IL3 may include an inorganic material such as silicon oxide, silicon nitride, silicon oxynitride, or the like. The fourth insulating layer IL4 may include an organic material such as polyimide-based resin, photoresist, polyacrylic-based resin, polyamide-based resin, siloxane-based resin, or the like. Each of these may be used alone or in combination with each other.

The pixel electrode layer PL may include first, second, and third pixel electrodes PE1, PE2, and PE3. The first, second, and third pixel electrodes PE1, PE2, and PE3 may include a same material and may be disposed in a same layer. The first, second, and third pixel electrodes PE1, PE2, and PE3 may be spaced apart from each other in the plan view.

The first pixel electrode PE1 may be connected to the second connection pattern CNP2 through a first via hole VH1. The first via hole VH1 may be formed by removing parts of the third and fourth insulating layers IL3 and IL4. Accordingly, the first pixel electrode PE1 may be electrically connected to the first driving transistor T11 through the second connection pattern CNP2.

The first pixel electrode PE1 may overlap the first switching active pattern SAP1 in the plan view. The first pixel electrode PE1 may overlap the first capacitor electrode CCE1 in the plan view. For example, the first pixel electrode PE1 may overlap the first storage capacitor CST1 in the plan view. In an embodiment, the first pixel electrode PE1 may overlap the entirety of the first storage capacitor CST1 in the plan view. For example, the first pixel electrode PE1 may overlap the entirety of a part of the first capacitor electrode CCE1 overlapping the first switching active pattern SAP1 in the plan view

Accordingly, the first switching active pattern SAP1 may be shielded by the first pixel electrode PE1. Formation of a parasitic capacitor between the first switching active pattern SAP1 and the common electrode CTE can be minimized or prevented.

A part of the first pixel electrode PE1 may overlap the entirety of the first gate electrode pattern GP1 in the plan view.

The second pixel electrode PE2 includes a first part PE2a spaced apart from the second switching active pattern SAP2 in the plan view and a second part PE2b extending from the first part PE2a and overlapping the second switching active pattern SAP2 in the plan view

The second pixel electrode PE2 may be connected to the fifth connection pattern CNP5 through a second via hole VH2. The second part PE2b of the second pixel electrode PE2 may be connected to the fifth connection pattern CNP5 through the second via hole VH2. The second via hole VH2 may be formed by removing parts of the third and fourth insulating layers IL3 and IL4. Accordingly, the second pixel electrode PE2 may be electrically connected to the second driving transistor T12 through the fifth connection pattern CNP5.

The second part PE2b of the second pixel electrode PE2 may also overlap the second capacitor electrode CCE2 in the plan view. For example, the second pixel electrode PE2 may overlap the second storage capacitor CST2 in the plan view. In an embodiment, a part (e.g., the second part PE2b) of the second pixel electrode PE2 may overlap the entirety of the second storage capacitor CST2 in the plan view. For example, the part of the second pixel electrode PE2 may overlap the entirety of a part of the second capacitor electrode CCE2 overlapping the second switching active pattern SAP2 in the plan view

Accordingly, the second switching active pattern SAP2 may be shielded by the second pixel electrode PE2. Formation of a parasitic capacitor between the second switching active pattern SAP2 and the common electrode CTE can be minimized or prevented.

A part of the second pixel electrode PE2 may overlap the entirety of the second gate electrode pattern GP2 in the plan view

The third pixel electrode PE3 may be connected to the eighth connection pattern CNP8 through a third via hole VH3. The third via hole VH3 may be formed by removing parts of the third and fourth insulating layers IL3 and IL4. Accordingly, the third pixel electrode PE3 may be electrically connected to the third driving transistor T13 through the eighth connection pattern CNP8.

The third pixel electrode PE3 may overlap the third switching active pattern SAP3 in the plan view. The third pixel electrode PE3 may overlap the third capacitor electrode CCE3 in the plan view. For example, the third pixel electrode PE3 may overlap the third storage capacitor CST3 in the plan view. In an embodiment, the third pixel electrode PE3 may overlap the entirety of the third storage capacitor CST3 in the plan view. For example, the third pixel electrode PE3 may overlap the entirety of a part of the third capacitor electrode CCE3 overlapping the third switching active pattern SAP3 in the plan view

Accordingly, the third switching active pattern SAP3 may be shielded by the third pixel electrode PE3. Formation of a parasitic capacitor between the third switching active pattern SAP3 and the common electrode CTE can be minimized or prevented.

A part of the third pixel electrode PE3 may overlap the entirety of the third gate electrode pattern GP3 in the plan view.

The pixel electrode layer PL may include a metal, an alloy, a conductive metal oxide, a transparent conductive material, or the like. Examples of the metal that can be used for the pixel electrode layer PL may include silver (Ag), molybdenum (Mo), aluminum (Al), tungsten (W), copper (Cu), nickel (Ni), chromium (Cr), titanium (Ti), tantalum (Ta), platinum (Pt), scandium (Sc), indium (In), or the like. Examples of the conductive metal oxide that can be used for the pixel electrode layer PL may include indium tin oxide (ITO), indium zinc oxide (IZO), indium tin zinc oxide (ITZO), or the like. Each of these may be used alone or in combination with each other. However, embodiments of the disclosure are not limited thereto.

A pixel defining layer (e.g., the pixel defining layer PDL of FIG. 3) may be disposed on the pixel electrode layer PL. A pixel opening exposing at least a part of an upper surface of each of the first, second, and third pixel electrodes PE1, PE2, and PE3 may be defined in the pixel defining layer.

The light emitting layer EL may be disposed on the pixel electrode layer PL and the pixel defining layer. The light emitting layer EL may be disposed on the first, second, and third pixel electrodes PE1, PE2, and PE3 exposed by the pixel opening and may continuously extend. For example, the light emitting layer EL may be disposed on a whole surface of the display area DA shown in FIG. 1. For example, the light emitting layer EL may have a multilayer structure including a hole injection layer, a hole transport layer, an organic light emitting layer, an electron transport layer, and an electron injection layer.

The common electrode CTE may be disposed on the light emitting layer EL. The common electrode CTE may be disposed on the whole surface of the display area DA shown in FIG. 1. For example, the common electrode CTE may include a metal, an alloy, a conductive metal oxide, a transparent conductive material, or the like. These may be used alone or in combination with each other.

Accordingly, the first pixel electrode PE1, the light emitting layer EL, and the common electrode CTE may constitute a first light emitting element LED1, the second pixel electrode PE2, the light emitting layer EL, and the common electrode CTE may constitute a second light emitting element LED2, and the third pixel electrode PE3, the light emitting layer EL, and the common electrode CTE may constitute a third light emitting element LED3. Each of the first, second, and third light emitting elements LED1, LED2, and LED3 may correspond to the light emitting element LED shown in FIG. 2.

In an embodiment, the first light emitting element LED1 may define a first sub-pixel (e.g., the first sub-pixel SPX1 of FIG. 1) that emits green light, the second light emitting element LED2 may define a second sub-pixel (e.g., the second sub-pixel SPX2 of FIG. 1) that emits red light, and the third light emitting element LED3 may define a third sub-pixel (e.g., the third sub-pixel SPX3 of FIG. 1) that emits blue light.

In other words, a pixel circuit of the first sub-pixel may be electrically connected to the first light emitting element LED1, and may include the first driving transistor T11, the first switching transistor T21, the first initialization transistor T31, and the first storage capacitor CST1. A pixel circuit of the second sub-pixel may be electrically connected to the second light emitting element LED2, and may include the second driving transistor T12, the second switching transistor T22, the second initialization transistor T32, and the second storage capacitor CST2. A pixel circuit of the third sub-pixel may be electrically connected to the third light emitting element LED3, and may include the third driving transistor T13, the third switching transistor T23, the third initialization transistor T33, and the third storage capacitor CST3.

The display device DD according to embodiments of the disclosure may include the first conductive layer CL1 disposed on the substrate SUB and including a capacitor electrode, the active layer ACT disposed on the first conductive layer CL1 and including a switching active pattern at least partially overlapping the capacitor electrode in the plan view and constituting a storage capacitor together with the capacitor electrode, the second conductive layer CL2 disposed on the active layer ACT, and the pixel electrode layer PL disposed on the second conductive layer CL2 and including a pixel electrode, a part of the pixel electrode overlapping the switching active pattern in the plan view

The switching active pattern may be electrically connected to a gate electrode of the driving transistor. A part of the pixel electrode may overlap the entirety of the storage capacitor in the plan view

Accordingly, formation of a parasitic capacitor between the switching active pattern and the common electrode CTE disposed on the switching active pattern can be minimized or prevented. The display quality of the display device DD can be improved.

The disclosure can be applied to various display devices. For example, the disclosure is applicable to various display devices such as display devices for vehicles, ships and aircraft, portable communication devices, display devices for exhibition or information transmission, medical display devices, or the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the disclosure. Accordingly, all such modifications are intended to be included within the scope of the disclosure. Therefore, it is to be understood that the foregoing is illustrative of various embodiments and is not to be construed as limited to the specific embodiments disclosed, and that modifications to the disclosed embodiments, as well as other embodiments, are intended to be included within the scope of the disclosure.

### Annex A

The present invention can also be defined by reference to the following clauses:
Clause 1. A display device comprising:
   a first conductive layer disposed on a substrate and including a capacitor electrode;
   an active layer disposed on the first conductive layer and including:
      a switching active pattern at least partially overlapping the capacitor electrode in a plan view and constituting a storage capacitor together with the capacitor electrode; and
      a driving active pattern at least partially overlapping the capacitor electrode in the plan view
   a second conductive layer disposed on the active layer and including a gate electrode pattern at least partially overlapping the driving active pattern in the plan view and constituting a driving transistor together with the driving active pattern;
   a pixel electrode layer disposed on the second conductive layer and including a pixel electrode, the pixel electrode including:
      a first pixel electrode electrically connected to the driving transistor, a part of the first pixel electrode overlapping the switching active pattern in the plan view;
      a second pixel electrode spaced apart from the first pixel electrode; and
      a third pixel electrode spaced apart from the first and second pixel electrodes; and
      a light emitting layer disposed on the pixel electrode layer.
Clause 2. The display device of clause 1, wherein the part of the first pixel electrode overlaps an entirety of the storage capacitor in the plan view.
Clause 3. The display device of clause 1 or clause 2, wherein the second conductive layer further includes a connection pattern at least partially overlapping the capacitor electrode in the plan view and being electrically connected to the driving active pattern through contact holes.
Clause 4. The display device of clause 3, wherein the part of the first pixel electrode is electrically connected to the connection pattern through a via hole.
Clause 5. The display device of any one of clauses 1 to 4, wherein the first pixel electrode overlaps an entirety of the gate electrode pattern in the plan view.
Clause 6. The display device of any one of clauses 1 to 5, wherein the gate electrode pattern is electrically connected to the switching active pattern through a contact hole.
Clause 7. The display device of any one of clauses 1 to 6, further comprising:
   a common electrode disposed on the light emitting layer, wherein
   the first pixel electrode, the light emitting layer, and the common electrode constitute a first light emitting element,
   the second pixel electrode, the light emitting layer, and the common electrode constitute a second light emitting element, and
   the third pixel electrode, the light emitting layer, and the common electrode constitute a third light emitting element.
Clause 8. The display device of clause 7, wherein
   the first light emitting element defines a first sub-pixel that emits red light,
   the second light emitting element defines a second sub-pixel that emits green light, and
   the third light emitting element defines a third sub-pixel that emits blue light.
Clause 9. The display device of any one of clauses 1 to 8, wherein the active layer further includes an initialization active pattern spaced apart from the driving active pattern and the switching active pattern in the plan view.
Clause 10. The display device of clause 9, wherein the second conductive layer further includes:
   a first scan line at least partially overlapping the switching active pattern in the plan view and constituting a switching transistor together with a part of the switching active pattern; and
   a second scan line at least partially overlapping the initialization active pattern in the plan view and constituting an initialization transistor together with a part of the initialization active pattern.

## Claims

1. A display device comprising:
a first conductive layer disposed on a substrate and including a capacitor electrode;
an active layer disposed on the first conductive layer and including a switching active pattern, the switching active pattern at least partially overlapping the capacitor electrode in a plan view and constituting a storage capacitor together with the capacitor electrode;
a second conductive layer disposed on the active layer;
a pixel electrode layer disposed on the second conductive layer and including a pixel electrode, the pixel electrode including:
a first part spaced apart from the switching active pattern in the plan view; and
a second part extending from the first part and overlapping the switching active pattern in the plan view; and
a light emitting layer disposed on the pixel electrode layer.

2. The display device of claim 1, wherein the second part of the pixel electrode overlaps an entirety of the storage capacitor in the plan view

3. The display device of claim 1 or claim 2, wherein the active layer further includes:
a driving active pattern at least partially overlapping the capacitor electrode in the plan view; and
an initialization active pattern spaced apart from the driving active pattern and the switching active pattern in the plan view,
wherein optionally the first conductive layer further includes:
a driving voltage line extending in a second direction and electrically connected to the driving active pattern;
a data line extending in the second direction, spaced apart from the driving voltage line in a first direction intersecting the second direction, and electrically connected to the switching active pattern; and
an initialization voltage line extending in the second direction, spaced apart from the driving voltage line in a direction opposite to the first direction, and electrically connected to the initialization active pattern.

4. The display device of claim 3, wherein the second conductive layer includes:
a gate electrode pattern at least partially overlapping the driving active pattern in the plan view and constituting a driving transistor together with the driving active pattern; and
a connection pattern at least partially overlapping the capacitor electrode in the plan view and electrically connected to the driving active pattern through contact holes,
wherein optionally the pixel electrode overlaps an entirety of the gate electrode pattern in the plan view

5. The display device of claim 4, wherein the gate electrode pattern is electrically connected to the switching active pattern through a contact hole,
wherein optionally the second part of the pixel electrode is electrically connected to the connection pattern through a via hole.

6. The display device of claim 4 or claim 5, further comprising:
a common electrode disposed on the light emitting layer, wherein
the pixel electrode, the light emitting layer, and the common electrode constitute a light emitting element, and
the light emitting element is electrically connected to the driving transistor,
wherein optionally the light emitting element defines a sub-pixel that emits red light.

7. The display device of any of claims 3 to 6, wherein the second conductive layer includes:
a first scan line at least partially overlapping the switching active pattern in the plan view and constituting a switching transistor together with a part of the switching active pattern; and
a second scan line at least partially overlapping the initialization active pattern in the plan view and constituting an initialization transistor together with a part of the initialization active pattern.

8. The display device of claim 7, wherein at least one of the first scan line and/or the second scan line includes:
a main part extending in a first direction; and
a branch part protruding and extending from the main part in a second direction intersecting the first direction,
wherein optionally the first scan line includes the respective branch part and the branch part of the first scan line at least partially overlaps the switching active pattern in the plan view,
wherein optionally the second scan line includes the respective branch part and the branch part of the second scan line at least partially overlaps the initialization active pattern in the plan view

9. The display device of any preceding claim, wherein the active layer includes a metal oxide semiconductor.

10. The display device of any preceding claim, comprising a driving active pattern at least partially overlapping the capacitor electrode in the plan view, wherein:
the switching active pattern is a second switching active pattern, the active layer further comprising a first switching active pattern;
the second conductive layer includes a gate electrode pattern at least partially overlapping the driving active pattern in the plan view and constituting a driving transistor together with the driving active pattern; and
the pixel electrode includes:
a first pixel electrode electrically connected to the driving transistor, a part of the first pixel electrode overlapping the first switching active pattern in the plan view;
a second pixel electrode spaced apart from the first pixel electrode, the second pixel electrode comprising the first part and the second part; and
a third pixel electrode spaced apart from the first and second pixel electrodes.

11. The display device of claim 10, wherein the capacitor electrode is a second capacitor electrode and the storage capacitor is a second storage capacitor,
wherein the first conductive layer includes a first capacitor electrode,
wherein the first switching active pattern at least partially overlaps the first capacitor electrode in a plan view and constitutes a first storage capacitor together with the first capacitor electrode,
wherein the part of the first pixel electrode overlaps an entirety of the first storage capacitor in the plan view

12. The display device of claim 10 or claim 11, wherein the second conductive layer further includes a connection pattern at least partially overlapping the first capacitor electrode in the plan view and being electrically connected to the driving active pattern through contact holes,
wherein optionally the part of the first pixel electrode is electrically connected to the connection pattern through a via hole.

13. The display device of any of claims 10 to 12, wherein the first pixel electrode overlaps an entirety of the gate electrode pattern in the plan view,
wherein optionally the gate electrode pattern is electrically connected to the first switching active pattern through a contact hole.

14. The display device of any of claims 10 to 13, further comprising:
a common electrode disposed on the light emitting layer, wherein:
the first pixel electrode, the light emitting layer, and the common electrode constitute a first light emitting element,
the second pixel electrode, the light emitting layer, and the common electrode constitute a second light emitting element, and
the third pixel electrode, the light emitting layer, and the common electrode constitute a third light emitting element,
wherein optionally:
the first light emitting element defines a first sub-pixel that emits red light,
the second light emitting element defines a second sub-pixel that emits green light, and
the third light emitting element defines a third sub-pixel that emits blue light.

15. The display device of any of claims 10 to 14, wherein the active layer further includes an initialization active pattern spaced apart from the driving active pattern and the first switching active pattern in the plan view,
wherein optionally, the second conductive layer further includes:
a first scan line at least partially overlapping the first switching active pattern in the plan view and constituting a switching transistor together with a part of the first switching active pattern; and
a second scan line at least partially overlapping the initialization active pattern in the plan view and constituting an initialization transistor together with a part of the initialization active pattern.
